# EUROPÄISCHE PATENTANMELDUNG

(11) **EP 0 947 848 A2**
(43) Veröffentlichungstag der Anmeldung: **06.10.1999**
(21) Anmeldenummer: 99105562.5
(22) Anmeldetag: 18.03.1999
(51) Int. Cl.: G01R 33/38

(54) **Magnet für Kernspinresonanzgeräte mit räumlich verschiebbarem Homogenitätsvolumen**

(30) Priorität: 31.03.1998 DE 29805903 U
(71) Anmelder: SIEMENS AKTIENGESELLSCHAFT, 80333 München (DE)
(72) Erfinder: Heid, Oliver, 91710 Gunzenhausen (DE)

(57) **Zusammenfassung**

Ein Magnet für Kernspinresonanzgeräte, der eine Patientenaufnahme (Patientenröhre) aufweist, innerhalb der das Homogenitätsvolumen liegt, ermöglicht dadurch, daß das Homogenitätsvolumen durch eine Zusatzeinrichtung räumlich verschiebbar ist, den Aufbau eines kostengünstigen und patientenfreundlichen Kernspinresonanzgerätes.

## Beschreibung

Die Erfindung betrifft einen Magneten für Kernspinresonanzgeräte.

Ein derartiger Magnet ist Bestandteil einer Magnetfelderzeugungseinheit eines Kernspinresonanzgerätes. Der Magnet weist eine Patientenröhre auf, in welcher ein Patient während seiner Untersuchung liegt. Die Magnetfelderzeugungseinheit erzeugt ein weitgehend homogenes und zeitlich konstantes (Haupt-)Magnetfeld (auch als Grundmagnetfeld oder B₀-Feld bezeichnet) in einem innerhalb der Patientenröhre liegenden Untersuchungsvolumen (Abbildungsvolumen). Aufgrund der notwendigen Homogenität des Untersuchungsvolumens wird dieses auch als Homogenitätsvolumen bezeichnet.

Die minimal erforderliche Ausdehnung des im allgemeinen kugelförmigen Homogenitätsvolumens wird dadurch bestimmt, daß an räumlich verschiedenen Positionen des Patienten Aufnahmen möglich sein müssen. So werden z. B. Kopfaufnahmen zentriert zur Magnetlängsachse vorgenommen, wohingegen die Herzbildgebung außerhalb der Magnetlängsachse erfolgt. Die benötigte Mindestausdehnung des Homogenitätsvolumens muß damit relativ groß gewählt werden, obwohl die zu untersuchenden Organe bzw. Körperregionen nur ein geringes Homogenitätsvolumen benötigen würden.

Die Ausdehnung des Homogenitätsvolumens wird im wesentlichen durch die Länge des Magneten bestimmt, wobei die Größe des Magneten aufgrund der geforderten Grundhomogenität zu einem entsprechend hohen Preis führt. Außerdem können bei derartig langen Patientenröhren, die mindestens so lang sind wie der Magnet selbst, beim Patienten während der Untersuchung Angstzustände auftreten.

Aufgabe der vorliegenden Erfindung ist es deshalb, einen Magneten zu schaffen, der den Aufbau eines kostengünstigen und patientenfreundlichen Kernspinresonanzgerätes ermöglicht.

Diese Aufgabe wird erfindungsgemäß durch die Merkmale des Anspruchs 1 gelöst. Vorteilhafte Ausgestaltungen der Erfindung sind in den weiteren Ansprüchen beschrieben.

Der Magnet gemäß Anspruch 1 weist eine Patientenaufnahme auf, innerhalb der das Homogenitätsvolumen liegt. Dieses Homogenitätsvolumen ist erfindungsgemäß durch eine Zusatzeinrichtung räumlich verschiebbar. Bei dem Magneten nach Anspruch 1 wird auf einfache Weise ein ΔB₀-Feld auf das B₀-Feld (Hauptmagnetfeld) aufgeprägt, wodurch eine räumliche Verschiebung und damit mehr als eine einzige Positionierung des Homogenitätsvolumens erreicht werden kann.

Die erfindungsgemäße Lösung ist für eine Vielzahl von Kernspinresonanzgeräten geeignet. So kann z. B. der Magnet als zylindrischer Magnet (als Solenoid) oder als Hufeisenmagnet (C-Bogen-Kernspinresonanzgerät) ausgebildet sein. Bei zylindrisch geformten Magneten ist die Patientenaufnahme als Patientenröhre ausgeführt.

Bei dem erfindungsgemäßen Magneten ist das Homogenitätsvolumen ausschließlich auf die Größe der zu untersuchenden Organe bzw. Körperregionen, wie z. B. Herz oder Kopf, abgestimmt. Damit weist der Magnet nach Anspruch 1 ein deutlich kleineres Homogenitätsvolumen auf, da die unterschiedliche Position der zu untersuchenden Organe bzw. Körperregionen bei der Dimensionierung des Homogenitätsvolumens nicht mehr berücksichtigt werden muß. Die unterschiedliche Lage der zu untersuchenden Organe bzw. Körperteile wird bei dem Magneten nach Anspruch 1 durch die Verschiebbarkeit des Homogenitätsvolumens berücksichtigt. Das gegenüber den bekannten Magneten kleinere Homogenitätsvolumen ist damit entsprechend aufwandsarm herzustellen, da der erfindungsgemäße Magnet kleiner, insbesondere kürzer, ausgebildet ist. Die geringere Länge des erfindungsgemäßen Magneten gegenüber herkömmlichen Magneten führt bei zylindrischen Magneten auch zu einer entsprechend kürzeren Patientenröhre, so daß sich dadurch auch eine größere Patientenfreundlichkeit sowie eine leichtere Zuganglichkeit ergibt.

Die bei einer Verschiebung des Homogenitätsfeldes eventuell auftretenden Feldinhomogenitäten lassen sich durch die üblichen Maßnahmen rechnerisch bestimmen und kompensieren.

Im Rahmen der Erfindung ist das Homogenitätsvolumen in alle Raumrichtungen verschiebbar. Im allgemeinen dürfte jedoch eine Verschiebbarkeit entlang der x-Achse ausreichend sein. Lediglich bei einem sehr kleinen Homogenitätsvolumen ist eine Verschiebbarkeit entlang der y-Achse (also senkrecht zur z-Achse und senkrecht zur x-Achse) notwendig. Eine Verschiebbarkeit des Homogenitätsvolumens in Richtung der z-Achse (d. h. in Richtung der Längsachse des Magneten) ist normalerweise nicht erforderlich, da in diesem Fall unter Umständen ein Verschieben der Patientenliege in der Patientenröhre einfacher ist.

Die Zusatzeinrichtung zur räumlichen Verschiebung des Homogenitätsvolumens kann entweder Verschiebe-Spulen (Ansprüche 2 und 4 sowie 6 und 8) oder ferromagnetische Verschiebe-Elemente (Ansprüche 3 und 5 sowie 7 und 9) umfassen. Auch eine Kombination von Verschiebe-Spulen und Verschiebe-Elementen kann zur räumlichen Verschiebung des Homogenitätsvolumens dienen.

Zwei Ausführungsbeispiele der Erfindung sind in der Zeichnung schematisch dargestellt und werden im folgenden näher beschrieben. Es zeigen:
- FIG 1: einen Magneten, dessen Zusatzeinrichtung mehrere Verschiebe-Spulen umfaßt,
- FIG 2: einen Magneten, dessen Zusatzeinrichtung mehrere ferromagnetische Verschiebe-Elemente umfaßt.

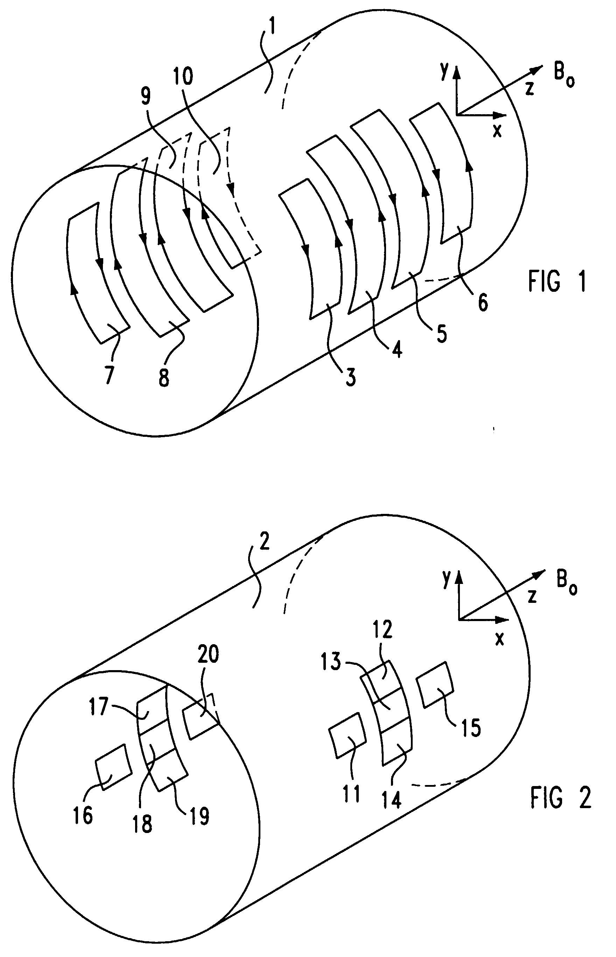

In den FIG 1 und 2 ist mit 1 bzw. 2 ein Magnet bezeichnet, der eine Patientenröhre aufweist und der bei Kernspinresonanzgeräten Bestandteil einer Magnetfelderzeugungseinheit ist. Die Magneten 1 und 2 sind in den FIG 1 und 2 nur als Rohre dargestellt. Die Hochfrequenzspule und die drei Gradientenspulen sowie die Patientenliege sind aus Gründen der Übersichtlichkeit nicht dargestellt. Die Magnetfelderzeugungseinheit erzeugt ein weitgehend homogenes und zeitlich konstantes B₀-Feld (auch als Grundmagnetfeld oder Hauptmagnetfeld bezeichnet) in einem innerhalb der Patientenröhre liegenden Homogenitätsvolumen (auch als Untersuchungsvolumen oder Abbildungsvolumen bezeichnet). Per definitionem liegt die z-Achse eines kartesischen Koordinatensystems in Richtung des B₀-Feldes. Die Ebene senkrecht zu den Feldlinien ist dann die xy-Ebene, wobei die x-Achse waagrecht und die y-Achse senkrecht verläuft.

Der in FIG 1 dargestellte Magnet 1 weist eine Zusatzeinrichtung aus mehreren Verschiebe-Spulen 3 bis 10 auf. Im dargestellten Ausführungsbeispiel sind jeweils vier Verschiebe-Spulen 3 bis 6 und 7 bis 10 gegenüberliegend und zu beiden Seiten des B₀-Feldes angeordnet. Zur Verschiebung des Homogenitätsvolumens in horizontaler Richtung und quer zum B₀-Feld (also in Richtung der x-Achse) müssen die Verschiebe-Spulen 3 bis 10 entsprechend mit Strom beaufschlagt werden. Die benachbarten Verschiebe-Spulen 3 bis 6 bzw. 7 bis 10 weisen einen gleichgerichteten Stromfluß auf und die jeweils gegenüberliegenden Verschiebespulen (das sind die Verschiebespulen 3 und 7 bzw. 4 und 8 bzw. 5 und 9 bzw. 6 und 10) werden so mit Strom beaufschlagt, daß ein entgegengerichteter Stromfluß entsteht. Der Stromfluß in den benachbarten Verschiebe-Spulen 3 bis 6 verläuft also gegen den Uhrzeigersinn, wohingegen der Stromfluß in den benachbarten Verschiebe-Spulen 7 bis 10 im Uhrzeigersinn verläuft. In FIG 1 sind die Stromflußrichtungen mit Pfeilspitzen gekennzeichnet.

Bei der in FIG 2 dargestellten Ausführungsform des Magneten 2 wird die erfindungsgemäße Verschiebung des Homogenitätsvolumens in horizontaler Richtung und quer zum B₀-Feld durch eine Zusatzeinrichtung aus mehreren ferromagnetischen VerschiebeElementen 11 bis 20 erreicht, die vorzugsweise als Eisenbleche ausgebildet sind.

Bei einer Kopfaufnahme, die zentriert zur Magnetlängsachse (z-Achse) erfolgt und damit keine Beeinflussung des B₀-Feldes erfordert, sind beim Magneten 1 die Verschiebespulen 3 bis 10 inaktiv (FIG 1) bzw. sind beim Magneten 2 die ferromagnetischen Verschiebe-Elemente 11 bis 20 herausgenommen (FIG 2). Wird dagegen eine Herzbildgebung gewünscht, die außerhalb der Magnetlängsachse vorzunehmen ist, werden am Magneten 1 die Verschiebe-Spulen 3 bis 10, wie vorstehend beschrieben, aktiviert bzw. es werden die betreffenden ferromagnetischen Verschiebe-Elemente 11 bis 15 bzw. 16 bis 20 am bzw. im Magneten 2 positioniert. Für die Verschiebe-Elemente 11 bis 20 können hierfür beispielsweise in FIG 2 nicht dargestellte Halterungen an der äußeren Mantelfläche des Magneten 2 vorgesehen sein, in denen die Verschiebe-Elemente 11 bis 20 einsetzbar sind.

Sowohl bei der Ausgestaltung gemäß FIG 1 als auch bei der in FIG 2 gezeigten Ausführungsform wird auf einfache Weise ein ΔB₀-Feld auf das B₀-Feld (Hauptmagnetfeld) aufgeprägt, wodurch eine räumliche Verschiebung und damit mehr als eine einzige Positionierung des Homogenitätsvolumens erreicht werden kann.

## Patentansprüche

1. Magnet für Kernspinresonanzgeräte, der eine Patientenaufnahme aufweist, innerhalb der das Homogenitätsvolumen liegt,
**dadurch gekennzeichnet,** daß
das Homogenitätsvolumen durch eine Zusatzeinrichtung räumlich verschiebbar ist.

2. Magnet nach Anspruch 1,
**dadurch gekennzeichnet,** daß
die Zusatzeinrichtung eine vorgebbare Anzahl von Verschiebe-Spulen (3 - 10) umfaßt, die am und/oder im Magneten (1) angeordnet sind und die entsprechend der gewünschten Verschieberichtung mit Strom beaufschlagbar sind.

3. Magnet nach Anspruch 1 oder 2,
**dadurch gekennzeichnet,** daß
die Zusatzeinrichtung eine vorgebbare Anzahl von ferromagnetischen Verschiebe-Elementen (11 - 20) umfaßt, die entsprechend der gewünschten Verschieberichtung am und/oder im Magneten (2) positionierbar sind.

4. Magnet nach Anspruch 2,
**dadurch gekennzeichnet,** daß
die Verschiebe-Spulen (3 - 10) zwischen den Gradientenspulen und den Abschirmspulen für die Abschirmung des Gradienten-Streufeldes angeordnet sind.

5. Magnet nach Anspruch 3,
**dadurch gekennzeichnet,** daß
die Verschiebe-Elemente (11 - 20) zwischen den Gradientenspulen und den Abschirmspulen für die Abschirmung des Gradienten-Streufeldes von der Stirnseite des Magneten (2) her einschiebbar sind.

6. Magnet nach Anspruch 2,
**dadurch gekennzeichnet,** daß
die Verschiebe-Spulen (3 - 10) zwischen den Gradientenspulen und dem Innenumfang des Magneten (1) angeordnet sind.

7. Magnet nach Anspruch 3,
**dadurch gekennzeichnet,** daß
die Verschiebe-Elemente (11 - 20) zwischen den Gradientenspulen und dem Innenumfang des Magneten (2) stirnseitig einschiebbar sind.

8. Magnet nach Anspruch 2, 4 oder 6,
**dadurch gekennzeichnet,** daß
die Verschiebe-Spulen (3 - 10) in Umfangsrichtung des Magneten (1) verdrehbar sind.

9. Magnet nach Anspruch 3, 5 oder 7,
**dadurch gekennzeichnet,** daß
die Verschiebe-Elemente (11 - 20) in Umfangsrichtung des Magneten (1) verdrehbar sind.
